# EUROPEAN PATENT SPECIFICATION

(11) **EP 3 557 770 B1**
(45) Date of publication and mention of the grant of the patent: **27.01.2021**
(21) Application number: 18465515.7
(22) Date of filing: 16.04.2018
(51) Int. Cl.: H05K 1/02, H05K 1/16, H05K 1/14

(54) **ELECTRIC INTERCONNECTOR SYSTEM**
ELEKTRISCHES VERBINDUNGSSYSTEM
SYSTÈME D'INTERCONNEXION ÉLECTRIQUE

(43) Date of publication of application: 23.10.2019
(73) Proprietor: Continental Automotive GmbH, 30165 Hannover (DE)
(72) Inventor: Craciun, Serban, 300687 Timisoara (RO); Ionescu, Ioana Sabina, 331042 Hunedoara (RO)

(56) References cited:
- US-A1- 2011 165 848

## Description

The invention is concerned with an interconnector system that connects two printed circuit boards of a device.

A multifunctional smartphone terminal (MFST) can comprise a sandwich structure, with multiple printed circuit boards (PCB). A main PCB at the bottom may be separated from an antenna PCB at the top by a charging coil, situated between the circuit boards. The main circuit board usually contains the electronics, the antenna circuit board contains a near field communication (NFC) antenna, a Global System for Mobile Communications (GSM) antenna and temperature sensors. The main circuit board and the antenna circuit board are connected by interconnectors. The interconnectors pass voltages (e.g. NFC, ground (GND), GSM diagnosis and temperature sensors) between the circuit boards. Usually two 4-connector line interconnectors are used to connect the two circuit boards. As each connection line is provided in the form of a wire, this requires that eight wires must be connected to both circuit boards. Thus, these interconnectors are expensive and occupy a lot of space on the main circuit board, which results in spatial restrictions concerning the design of the main circuit board.

US 2011/165848 A1 discloses two interconnected circuit boards of a laptop. The circuits contain diplexers separating high and low frequency voltages from a mixed frequency voltage which is received from a connecting cable of another circuit board.

It is an object of the present invention to provide a solution to reduce the number of interconnectors between the circuit boards.

The object is accomplished by the subject matter of the independent claims. Advantageous developments with convenient and non-trivial further embodiments of the invention are specified in the following description, the dependent claims and the figure.

In accordance with the object of the present invention, an interconnector system is disclosed, comprising a first circuit board, a second circuit board and an electrical interconnector comprising two connection lines between the first circuit board and the second circuit board. Each line may be, e.g., a wire. The first circuit board and the second circuit board each comprises at least one respective frequency separating filter. Such a frequency separating filter is also called diplexer. Each frequency separating filter comprises a high frequency connector a so called H port, a low frequency connector a so called L port and a mixed frequency connector a so called S port. At least one of the two connection lines is connected to the mixed frequency connector of one of the frequency separating filters of the first circuit board and to the mixed frequency connector of one of the frequency separating filters of the second circuit board. The low frequency is a lower of two frequencies and the high frequency is the higher of two frequencies.

In other words, an embodiment of the invention provides an interconnection system, comprising the first circuit board and the second circuit board, wherein the first circuit board and the second circuit board are connected by the electrical interconnector. The connection of the first circuit board and the second circuit board is accomplished via the at least one respective frequency separating filter of the first circuit board and the at least one respective frequency separating filter of the second circuit board. More precisely, the connection is provided via at least one of the two connection lines of the interconnector with the respective mixed frequency connector of one of the frequency separating filters of the first circuit board being connected to the respective mixed frequency connector of one of the frequency separating filters of the second circuit board by a respective connection line of the interconnector.

The frequency separating filters may be analogue frequency separating filters. The low frequency connector may be a low pass filter which may be provided on the basis of an inductor and the high frequency connector may be a high pass filter which may be provided on the basis of a capacitor. The mixed frequency connector may be connected to the high frequency connector and the low frequency connector via the high pass filter and the low pass filter, respectively. The high pass filter may have a cut off frequency which is below the high frequency and above the low frequency. Therefore, the high frequency may pass the high pass filter, while the low frequency may be reduced. The low pass filter may have a cut off frequency which is below the high frequency and above the low frequency. Therefore, the low frequency may pass the low pass filter, while the high frequency may be reduced. The high pass filter and the low pass filter may be directionally operable. The capacitance of the capacitor and the inductance of the inductor may be selected to provide a defined crossover frequency of the frequency separating filter.

The high frequency connector of one of the frequency separating filters of the first circuit board may be intended to receive a high frequency voltage of the first circuit board. The low frequency connector of one of the frequency separating filters of the first circuit board may be intended to receive a low frequency voltage of the first circuit board. The frequency separating filter of the first circuit board may be designed to combine the high frequency and the low frequency voltage to a mixed frequency voltage, which may be provided at the respective mixed frequency connector. Thus, the frequency separator filter is operated in an in-verse manner in that it combines input signals from the high frequency connector and the low frequency connector at the mixed frequency connector. The frequency separator filters are preferable bidirectionally operable.

The mixed frequency connector of the frequency separating filter of the first circuit board may be connected to the mixed frequency connector of the frequency separating filter of the second circuit board by one of the connection lines of the interconnector. The connection line may be intended to conduct the mixed frequency voltage of the mixed frequency connector of the frequency separating filter of the first circuit board to the mixed frequency connector of the frequency separating filter of the second circuit board. The frequency separating filter of the second circuit board may be designed to separate the mixed frequency voltage into the high frequency voltage and the low frequency voltage. The high frequency voltage may be provided at the high frequency connector of the frequency separating filter of the second circuit board and the low frequency voltage may be provided at the low frequency connector of the frequency separating filter of the second circuit board. Thus, two signals of different frequency ranges (i.e. the high frequency voltage and the low frequency voltage) may be transmitted over a single 2-line interconnector. On the second circuit board they may still be presented as separate signals.

The invention has the advantage that two circuit boards may be connected by just one single 2-line interconnector.

The invention also comprises embodiments that provide features which afford additional technical advantages.

In accordance with a further embodiment, the system is provided, wherein each of the high frequency connectors is connected to a respective high frequency circuit of the first and the second circuit board, and each of the low frequency connectors is connected to a respective low frequency circuit of the first and the second circuit board.

In other words, the first circuit board and the second circuit board each comprise a respective high frequency circuit and a respective low frequency circuit. Each high frequency connector of the at least one frequency separating filter of the first circuit board is connected to the high frequency circuit of the first circuit board. Each high frequency connector of the at least one frequency separating filter of the second circuit board is connected to the high frequency circuit of the second circuit board. Each low frequency connector of the at least one frequency separating filter of the first circuit board is connected to the low frequency circuit of the first circuit board. Each low frequency connector of the at least one frequency separating filters of the second circuit board is connected to the low frequency circuit of the second circuit board. This embodiment has the advantage that the circuit on the first circuit board can be connected with the corresponding circuit on the second circuit board without interfering with another circuit that operates at a different frequency.

As an example, it is possible that the first circuit board and the second circuit board each comprise the high frequency circuit, operated at above 100 Hz and the low frequency circuit, operated at below 50 Hz. The high frequency circuits may be connected to the high frequency connector of the frequency separating filter of the respective circuit board. The low frequency circuits may be connected to the low frequency connector of the frequency separating filter of the respective circuit board. The low frequency circuit and the high frequency circuit of the first circuit board may be connected to the corresponding circuit of the second circuit board over the interconnector.

In accordance with a further embodiment, each of the high frequency connectors is connected to a respective AC circuit of the first and the second circuit board (AC - alternating current), and each of the low frequency connectors is connected to a respective DC circuit of the first and the second circuit board (DC - directed current).

In other words, each of the high frequency connectors of the frequency separating filters is connected to a respective AC circuit and each of the low frequency connectors of the frequency separating filters is connected to a respective DC circuit. This embodiment provides the advantage, that an AC circuit and a DC circuit of the first circuit board are connected to a corresponding circuit on the second circuit board over the interconnector.

As an example, the high frequency circuit may be an AC circuit, operated at above 50 Hz and the low frequency circuit may be a DC circuit, operated at below 10 Hz.

In accordance with a further embodiment, the second circuit board comprises at the high frequency connector a respective impedance matching circuit comprising a grounded capacitor and a serial capacitor. The serial capacitor is a high pass filter of one of the impedance matching circuits of the second circuit board.

In other words, the second circuit board comprises the serial capacitor, wherein the capacitance of the serial capacitor is selected to match to the high pass filter of the frequency separating filter. The capacitance of the serial capacitor matches to a respective impedance matching circuit. This embodiment provides the advantage, that the capacitor can be used as a high pass filter and a serial capacitor of an impedance matching circuit.

For example, the capacitance of the serial capacitor may be selected to provide the high frequency voltage of the mixed frequency voltage at the high frequency connector. The capacitor may be the serial capacitor of an impedance matching circuit. The impedance matching circuit may comprise a grounded capacitor, wherein the capacitance of the serial capacitor and the capacitance of the grounded capacitor are selected to match a desired impedance.

In another embodiment of the invention, the second circuit board comprises an antenna driver unit connected to the high frequency connector of the frequency separating filter of the second circuit board, and the first circuit board comprises an antenna driver unit connected to the high frequency connector of the frequency separating filter of the first circuit board.

In other words, the high frequency connector of the frequency separating filter of the first circuit board is connected to the antenna driver unit of the first circuit board and the high frequency connector of the frequency separating filter of the second circuit board is connected to the antenna of the second circuit board. This embodiment gives the advantage that the antenna can be connected to the corresponding antenna driver unit.

As an example, the antenna of the second circuit board may be a Wi-Fi antenna, designed to receive or send high frequency voltages at around 5 GHz. The antenna may be connected to the high frequency connector of the frequency separating filter of the second circuit board. The crossover frequency of the frequency separating filter may be set below 5 GHz. The frequency separating filter may be designed to combine the high frequency voltage of the antenna with the low frequency voltage to the mixed frequency voltage. The mixed frequency connector of the frequency separating filter of the second circuit board may be connected to the mixed frequency connector of the frequency separating filter of the first circuit board. The crossover frequency of the frequency separating filter of the first circuit board may be set below 5 GHz. The frequency separating filter may be designed to separate the mixed frequency voltage and to provide the high frequency voltage at the respective high frequency connector. The high frequency connector of the first circuit board may be connected to the antenna driving unit. The antenna control unit may be a driver and a microprocessor corresponding to the antenna.

As a further embodiment, the antenna is a NFC and/or GSM and/or Bluetooth antenna. In other words, the antenna is set up to receive or send voltages corresponding to near field communication standard and/or GSM standard and/or Bluetooth standard. This embodiment gives the advantage that voltages of communication standards can be transmit through the interconnector.

As an example, the Bluetooth antenna on the second circuit board may be connected to the high frequency connector of the frequency separating filter of the second circuit board. The Bluetooth antenna driving unit on the first circuit board may be connected to the high frequency connector of the frequency separating filter of the first circuit board. Each high frequency connector may be set to transmit frequencies between 2.402 GHz and 2.480 GHz.

As a further embodiment, the second circuit board comprises a sensor connected to the low frequency connector of the frequency separating filter of the second circuit board and the first circuit board comprises a sensor control unit connected to the low frequency connector of the frequency separating filter of the first circuit board. In other words, the low frequency connector of the frequency separating filter of the second circuit board is connected to the sensor of the second circuit board. The low frequency connector of the frequency separating filter of the first circuit board is connected to the sensor control unit of the first circuit board. This embodiment gives the advantage that the interconnector can be used to transmit sensor voltages between the circuit boards. As an example, the first sensor may be a temperature sensor driven at DC voltage. The sensor control unit may be the related control unit to interpret the DC voltages of the sensor.

As a further embodiment, the first circuit board comprises a low-pass filter, wherein the antenna control unit is connected to the high frequency connector of the frequency separating filter of the first circuit board via the low pass filter.

In other words, the high frequency connector of the frequency separating filter of the first circuit board is connected to a low-pass filter, which is connected to the antenna control unit. This embodiment provides the advantage that noise can be filtered.

As an example, the cut-off frequency of the high frequency connector of the frequency separating filter of the first circuit board may be selected to provide NFC voltages at the high frequency output. The high frequency connector may be connected to the low pass filter, which has a defined cut-off frequency to filter out noise of the NFC voltage. The low-pass filter may be connected to the antenna control unit.

As a further embodiment, the first circuit board and the second circuit board are packaged in a sandwich arrangement in a same housing.

In other words the first circuit board and the second circuit board are arranged above each other in order to form the sandwich package, Therein the first circuit board and the second circuit board are arranged in the same housing.

This embodiment gives the advantage, that the circuit boards may be arranged in a compact design.

As an example, the first circuit board may be the main circuit board, comprising control units and the second circuit board may be a circuit board, comprising the antenna and sensors. The first circuit board may be arranged in parallel below the second circuit board. The first circuit board and the second circuit board may be separated by another circuit board or an induction coil. The first circuit board and the second circuit board may be arranged in the same housing. The housing may be the housing of a smart phone or another mobile device.

The invention also comprises a method to transfer a low frequency voltage and a high frequency voltage between a first circuit board and a second circuit board.

In a first step the high frequency is transmitted to a high frequency connector of a frequency separating filter of one of the circuit boards. The low frequency voltage is transmitted to a low frequency connector of the frequency separating filter of one of the circuit boards. In the next step the high frequency voltage and the low frequency voltage is combined to the mixed frequency voltage by the frequency separating filter. In the next step the mixed frequency voltage is transmitted from the mixed frequency connector of the frequency separating filter to the mixed frequency connector of a frequency separating filter of the other of the two circuit boards via the connection line of an interconnector. The mixed frequency voltage is separated to the high frequency voltage and the low frequency voltage. The high frequency voltage is provided at a high frequency connector of the frequency separating filter of the other of the two circuit boards and the low frequency voltage is provided at a low frequency connector of the frequency separating filter of the other circuit board.

In the following an exemplary implementation of the invention is described. The figures show:
Fig. 1 a schematic illustration of a state-of-the-art interconnection system;
Fig. 2 a schematic illustration of an embodiment of the inventive interconnection system; and
Fig. 3 a schematic illustration of an embodiment of the packaging of the inventive interconnection system; and
Fig. 4 a schematic illustration of an embodiment of the method to transfer a low frequency voltage and a high frequency voltage.

The embodiment explained in the following is a preferred embodiment of the invention. However, in the embodiment, the described components of the embodiment each represent individual features of the invention which are to be considered independently of each other and which each develop the invention also independently of each other and thereby are also to be regarded as a component of the invention in individual manner or in another than the shown combination. Furthermore, the described embodiment can also be supplemented by further features of the invention already described.

In the figures elements that provide the same function are marked with identical reference signs.

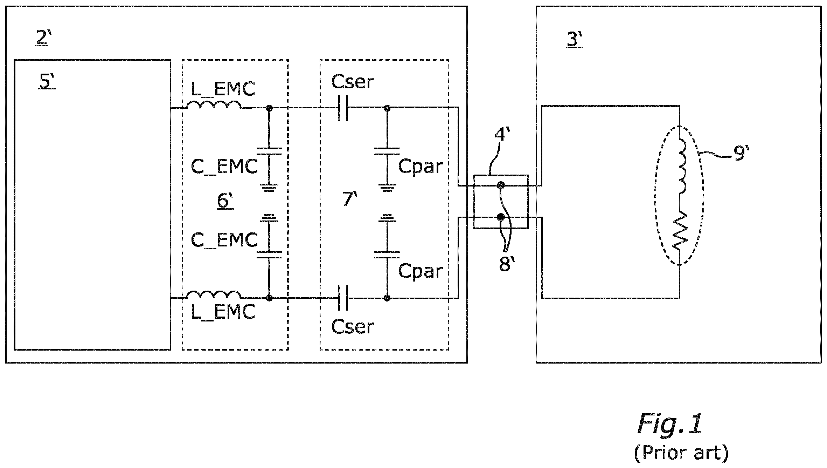

Fig. 1 is a schematic illustration of a state-of-the-art interconnection system. The interconnection system 1' comprises the first circuit board 2', the second circuit board 3' and the interconnector 4'. The first circuit board 2' comprises the antenna driving unit 5' the low-pass filter 6' and an impedance matching circuit 7'. The low pass filter 6' may comprise two inductors L_EMC' and two grounded capacitors C_EMC'. The impedance matching circuit 7' may comprise two serial capacitors Cser and two grounded capacitors Cpar. The interconnector 4' may comprise two connection lines 8'. The second circuit board 3' may comprise the antenna 9', which may be an NFC antenna. In order to connect the antenna 9' of the second circuit board 3' and the antenna driving unit 5' on the first circuit board 2', the antenna may be connected by two connection lines 8' of the interconnector 4'.

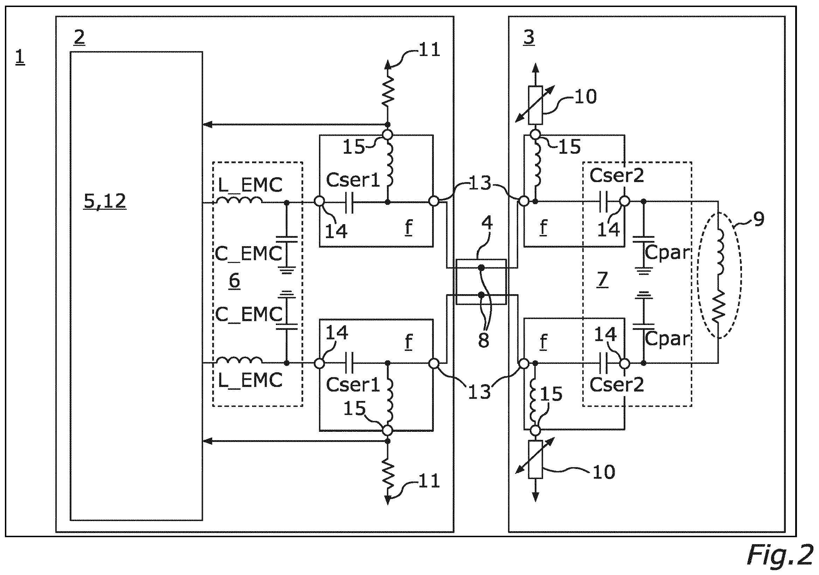

Fig. 2 is a schematic illustration of an embodiment of the inventive interconnection system. The interconnection system 1 comprises the first circuit board 2, the second circuit board 3 and the interconnector 4. The first circuit board 2 comprises the antenna driving unit 5 and the low-pass filter 6. The low-pass filter 6 may comprise two inductors L_EMC and two grounded capacitors C_EMC. The interconnector 4 may comprise two connection lines 8. The second circuit board 3 may comprise the antenna 9, which may be an NFC antenna. The second circuit board may comprise two sensors 10, which may be temperature sensors.

The first circuit board 2 may comprise two sensor driver units 11 to drive the sensors 10. The sensor driver units 11 may be connected to a sensor control unit 12. The first circuit board and the second circuit board may comprise two respective frequency separating filters f. each frequency separating filter may comprise a mixed frequency voltage connector 13, a high frequency connector 14 and a low frequency connector 15. Each mixed frequency connector 13 of one of the circuit boards 2, 3 may be connected to a respective mixed frequency connector 13 of the other circuit board 2, 3 via the connection line 8 of the interconnector 4. The high frequency connectors 14 on the first circuit board 2 may be connected to the low-pass filter 6. The high frequency connectors 14 of the second circuit board 3 may be connected to the antenna 9 of the second circuit board 3. The high frequency connectors 14 may contain a respective capacitor Cser1, Cser2, wherein the capacitors of the second circuit board Cser2 may form the impedance matching circuit 7 on the second circuit board 3. The impedance matching circuit 7 on the second circuit board 3 may also contain two grounded capacitors Cpar. The low frequency connectors 15 on the second circuit board 3 may be connected to the sensors 10. The low frequency connectors 15 may contain an inductor. The low frequency connectors 15 on the first circuit board 2 may be connected to the sensor driver unit 11 and the sensor control unit 12.

In order to connect the sensors 10 on the second circuit board 3 with the sensor driver unit 11 and the sensor control unit 12 on the first circuit board 2, the respective units 10, 11, 12 are connected to the low frequency connectors 15 of the respective circuit board 2, 3. As the mixed frequency connectors 13 of the two circuit boards 2, 3 are connected by the connection lines 8 of the interconnector 4, a low frequency circuit is formed, connecting the sensors 10 on the second circuit board 3 with the sensor control unit 12 and the sensor driver unit 11 on the first circuit board 2.

In order to connect the antenna 9 on the second circuit board 3 with the antenna driving unit 5 on the first circuit board 2, the antenna 9 is connected to the high frequency connectors 14 of the second circuit board 3 and the antenna driving unit 5 is connected to the high frequency connectors 14 of the first circuit board 2. As the mixed frequency connectors 13 of the two circuit boards 2, 3 are connected by the connection lines 8 of the interconnector 4, a high frequency circuit is formed, connecting the antenna 9 on the second circuit board 3 with the antenna driving unit 5 on the first circuit board 2. To match the desired impedance, the high frequency circuit may contain the impedance matching circuit 7.

The high frequency connectors 14 may have capacitors, which transmit only high frequency voltages. The low frequency connectors 15 may have inductors, which transmit only low frequency voltages. Mixed frequency connectors 13 may transmit mixed frequency voltage, containing high frequency voltages and low frequency voltages. This way, it is possible to connect the high frequency circuit and the low frequency circuit of one circuit board with a respective counterpart of the other board.

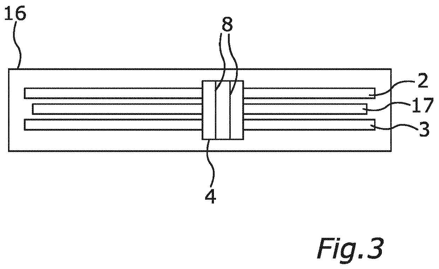

Fig. 3 is a schematic illustration of a packaging of the inventive interconnection system. The first circuit board 2 and the second circuit board 3 may be arranged in the same housing 16. The first circuit board 2 and the second circuit board 3 may be in parallel and arranged in a sandwich structure, separated by an induction coil 17. The first circuit board 2 and the second circuit board 3 may be connected by the interconnector 4, comprising the two connection lines 8.

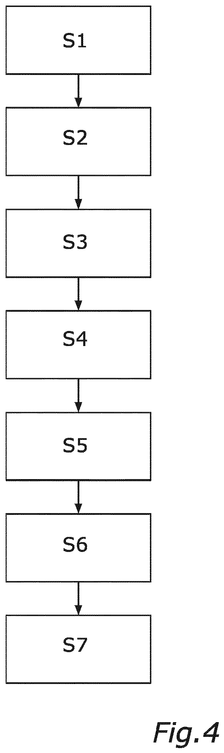

Fig. 4 is a schematic illustration of an embodiment of the method to transfer a low frequency voltage and a high frequency voltage between a first circuit board 2 and a second circuit board 3. The first step S1 may consist of transmitting the high frequency voltage to a high frequency connector 14 of a frequency separating filter f of one of the two circuit boards 2, 3. The low frequency voltage may be transmitted to a low frequency connector 15 of the frequency separating filter f of one of the two circuit boards 2, 3 (step S2). In a next step S3, the high frequency voltage and the low frequency voltage may be combined to a mixed frequency voltage. In a next step S4 the mixed frequency voltage may be transmitted from a mixed frequency connector 13 of the frequency separating filter f of the first circuit board 2 to a mixed frequency connector 13 of a frequency separating filter f of the other of the two circuit boards 2, 3. The mixed frequency voltage may be separated back into the high frequency voltage and the low frequency voltage (step S5). The high frequency voltage may be provided at a high frequency connector 14 of a frequency separating filter f of the other of the two circuit boards 2, 3 (step S6), and the low frequency voltage may be provided at a low frequency connector 15 of a frequency separating filter f of the other of the two circuit boards 2, 3 (step S7).

Overall, the example shows how a solution to reduce the number of interconnectors between the circuit boards is provided by the invention.

### Reference signs

- 1: system
- 2: first circuit board
- 3: second circuit board
- 4: interconnector
- 5: antenna driving unit
- 6: low-pass filter
- 7: impedance matching circuit
- 8: line
- 9: antenna
- 10: sensor
- 11: sensor driver unit
- 12: sensor control unit
- 13: mixed frequency connector
- 14: high-frequency connector
- 15: low-frequency connector
- 16: housing
- 17: induction coil
- Cser: serial capacitor
- Cser1: serial capacitor
- Cser2: serial capacitor
- Cpar: grounded capacitor
- L_EMC: inductor
- C_EMC: capacitor
- f: frequency separating filter
- S1-S7: steps of the method

## Claims

1. An interconnector system (1) comprising a first circuit board (2), a second circuit board (3) and an electrical interconnector (4) comprising two connection lines (8) between the first circuit board (2) and the second circuit board (3), wherein the first circuit board (2) and the second circuit board (3) each comprise at least one respective frequency separating filter (f), each frequency separating filter (f) comprising a high frequency connector (14), a low frequency connector (15) and a mixed frequency connector (13),
**characterized in that**
at least one of the two connection lines (8) is connected to the mixed frequency connector (13) of one of the frequency separating filters (f) of the first circuit board (2) and to the mixed frequency connector (13) of one of the frequency separating filters (f) of the second circuit board (3).

2. The system (1) of claim 1, wherein each of the high frequency connectors (14) is connected to a respective high frequency circuit of the first and the second circuit board (2, 3), and
each of the low frequency connectors (15) is connected to a respective low frequency circuit of the first and the second circuit board (2, 3), wherein each low frequency circuit is designed to operate at a frequency that is lower than a frequency at which each high frequency circuit is designed to operate.

3. The system (1) of claim 1 or 2, wherein each of the high frequency connectors (14) is connected to a respective AC circuit of the first and the second circuit board (2, 3), and each of the low frequency connectors (15) is connected to a respective DC circuit of the first and the second circuit board (2, 3).

4. The system (1) as claimed in any preceding claim, wherein the second circuit board (3) comprises at the high frequency connector (14) a respective impedance matching circuit (7) comprising a grounded capacitor (Cpar) and a serial capacitor (Cser2), wherein the serial capacitor (Cser2) is a high pass filter of one of the frequency separating filters (f) of the second circuit board (3).

5. The system (1) as claimed in any preceding claim, wherein the second circuit board (3) comprises an antenna (9) connected to the high frequency connector (14) of the frequency separating filter (f) of the second circuit board (3), and the first circuit board (2) comprises an antenna driver unit (5) connected to the high frequency connector (14) of the frequency separating filter (f) of the first circuit board (2) .

6. The system (1) of claim 5, wherein the antenna (9) is a NFC and/or GSM and/or Bluetooth antenna.

7. The system (1) as claimed in any preceding claim, wherein the second circuit board (3) comprises a sensor (10) connected to the low frequency connector (15) of the frequency separating filter (f) of the second circuit board (3)and the first circuit board (2) comprises a sensor control unit (12) connected to the low frequency connector (15) of the frequency separating filter (f) of the first circuit board (2) .

8. The system (1) of claim 5, wherein the first circuit board (2) comprises a low pass filter (6), and the antenna control unit (12) is connected to the frequency separating filters (14) of the first circuit board (2) via the low pass filter (6) .

9. The system (1) as claimed in any preceding claim, wherein the first circuit board (2) and the second circuit board (3) are packaged in a sandwich arrangement in a same housing (16) .

10. A method to transfer a low frequency voltage and a high frequency voltage between a first circuit board (2) and a second circuit board (3) containing the steps of:
- transmitting the high frequency voltage to a high frequency connector (14) of a frequency separating filter (f) of one of the two circuit boards (2, 3),
- transmitting the low frequency voltage to a low frequency connector (15) of the frequency separating filter (f) of one of the two circuit boards (2, 3),
- combining the high frequency voltage and the low frequency voltage to a mixed frequency voltage,
- transmitting the mixed frequency voltage from a mixed frequency connector (13) of the frequency separating filter (f) of the first circuit board (2) to a mixed frequency connector (13) of a frequency separating filter (f) of the other of the two circuit boards (2, 3),
- separating the mixed frequency voltage back into the high frequency voltage and the low frequency voltage,
- providing the high frequency voltage at a high frequency connector (14) of a frequency separating filter (f) of the other of the two circuit boards (2, 3), and
- providing the low frequency voltage at a low frequency connector (15) of a frequency separating filter (f) of the other of the two circuit boards (2, 3).

## Patentansprüche

1. Verbindungssystem (1), das eine erste Leiterplatte (2), eine zweite Leiterplatte (3) und einen elektrischen Verbindungsstecker (4), der zwei Verbindungsleitungen (8) aufweist, zwischen der ersten Leiterplatte (2) und der zweiten Leiterplatte (3) aufweist, wobei die erste Leiterplatte (2) und die zweite Leiterplatte (3) jeweils mindestens ein jeweiliges Frequenztrennfilter (f) aufweisen, wobei jedes Frequenztrennfilter (f) einen Hochfrequenzverbindungsstecker (14), einen Niederfrequenzverbindungsstecker (15) und einen Verbindungsstecker gemischter Frequenz (13) aufweist, **dadurch gekennzeichnet, dass**
mindestens eine der beiden Verbindungsleitungen (8) mit dem Verbindungsstecker gemischter Frequenz (13) eines der Frequenztrennfilter (f) der ersten Leiterplatte (2) und mit dem Verbindungsstecker gemischter Frequenz (13) eines der Frequenztrennfilter (f) der zweiten Leiterplatte (3) verbunden ist.

2. System (1) nach Anspruch 1, wobei jeder der Hochfrequenzverbindungsstecker (14) mit einer jeweiligen Hochfrequenzschaltung der ersten und der zweiten Leiterplatte (2, 3) verbunden ist und
jeder der Niederfrequenzverbindungsstecker (15) mit einer jeweiligen Niederfrequenzschaltung der ersten und der zweiten Leiterplatte (2, 3) verbunden ist, wobei jede Niederfrequenzschaltung so entworfen ist, dass sie bei einer Frequenz arbeitet, die niedriger als eine Frequenz ist, bei der die Hochfrequenzschaltung zu arbeiten entworfen ist.

3. System (1) nach Anspruch 1 oder 2, wobei jeder der Hochfrequenzverbindungsstecker (14) mit einer jeweiligen AC-Schaltung der ersten und der zweiten Leiterplatte (2, 3) verbunden ist und jeder der Niederfrequenzverbindungsstecker (15) mit einer jeweiligen DC-Schaltung der ersten und der zweiten Leiterplatte (2, 3) verbunden ist.

4. System (1) nach einem vorhergehenden Anspruch, wobei die zweite Leiterplatte (3) an dem Hochfrequenzverbindungsstecker (14) eine jeweilige Impedanzanpassungsschaltung (7) aufweist, die einen geerdeten Kondensator (Cpar) und einen Reihenkondensator (Cser2) aufweist, wobei der Reihenkondensator (Cser2) ein Hochpassfilter eines der Frequenztrennfilter (f) der zweiten Leiterplatte (3) ist.

5. System (1) nach einem vorhergehenden Anspruch, wobei die zweite Leiterplatte (3) eine Antenne (9) aufweist, die mit dem Hochfrequenzverbindungsstecker (14) des Frequenztrennfilters (f) der zweiten Leiterplatte (3) verbunden ist, und die erste Leiterplatte (2) eine Antennenansteuerungseinheit (5) aufweist, die mit dem Hochfrequenzverbindungsstecker (14) des Frequenztrennfilters (f) der ersten Leiterplatte (2) verbunden ist.

6. System (1) nach Anspruch 5, wobei die Antenne (9) eine NFC- und/oder GSM- und/oder Bluetooth-Antenne ist.

7. System (1) nach einem vorhergehenden Anspruch, wobei die zweite Leiterplatte (3) einen Sensor (10) aufweist, der mit dem Niederfrequenzverbindungsstecker (15) des Frequenztrennfilters (f) der zweiten Leiterplatte (3) verbunden ist und die erste Leiterplatte (2) eine Sensorsteuereinheit (12) aufweist, die mit dem Niederfrequenzverbindungsstecker (15) des Frequenztrennfilters (f) der ersten Leiterplatte (2) verbunden ist.

8. System (1) nach Anspruch 5, wobei die erste Leiterplatte (2) ein Tiefpassfilter (6) aufweist und die Antennensteuereinheit (12) mit den Frequenztrennfiltern (14) der ersten Leiterplatte (2) über das Tiefpassfilter (6) verbunden ist.

9. System (1) nach einem vorhergehenden Anspruch, wobei die erste Leiterpatte (2) und die zweite Leiterplatte (3) in einer Sandwichanordnung in demselben Gehäuse (16) verpackt sind.

10. Verfahren, um eine Niederfrequenzspannung und eine Hochfrequenzspannung zwischen einer ersten Leiterpatte (2) und einer zweiten Leiterplatte (3) zu übertragen, das die folgenden Schritte enthält:
- Senden der Hochfrequenzspannung an einen Hochfrequenzverbindungsstecker (14) eines Frequenztrennfilters (f) einer der beiden Leiterplatten (2, 3),
- Senden der Niederfrequenzspannung an einen Niederfrequenzverbindungsstecker (15) des Frequenztrennfilters (f) einer der beiden Leiterplatten (2, 3),
- Vereinigen der Hochfrequenzspannung und der Niederfrequenzspannung zu einer Spannung gemischter Frequenz,
- Senden der Spannung gemischter Frequenz von einem Verbindungsstecker gemischter Frequenz (13) des Frequenztrennfilters (f) der ersten Leiterplatte (2) an einen Verbindungsstecker gemischter Frequenz (13) eines Frequenztrennfilters (f) der anderen der beiden Leiterplatten (2, 3),
- Trennen der Spannung gemischter Frequenz zurück in die Hochfrequenzspannung und die Niederfrequenzspannung,
- Liefern der Hochfrequenzspannung an einem Hochfrequenzverbindungsstecker (14) eines Frequenztrennfilters (f) der anderen der beiden Leiterplatten (2, 3) und
- Liefern der Niederfrequenzspannung an einem Niederfrequenzverbindungsstecker (15) eines Frequenztrennfilters (f) der anderen der beiden Leiterplatten (2, 3).

## Revendications

1. Système d'interconnexion (1) comprenant une première carte de circuit imprimé (2), une seconde carte de circuit imprimé (3) et un dispositif d'interconnexion électrique (4) comprenant deux lignes de connexion (8) entre la première carte de circuit imprimé (2) et la seconde carte de circuit imprimé (3), où la première carte de circuit imprimé (2) et la seconde carte de circuit imprimé (3) comprennent chacune au moins un filtre de séparation de fréquences respectif (f), chaque filtre de séparation de fréquences (f) comprenant un connecteur haute fréquence (14), un connecteur basse fréquence (15) et un connecteur à fréquences mélangées (13), **caractérisé en ce que** :
au moins l'une des deux lignes de connexion (8) est connectée au connecteur à fréquences mélangées (13) d'un des filtres de séparation de fréquences (f) de la première carte de circuit imprimé (2) et au connecteur à fréquences mélangées (13) d'un des filtres de séparation de fréquences (f) de la seconde carte de circuit imprimé (3).

2. Système (1) selon la revendication 1, dans lequel chacun des connecteurs haute fréquence (14) est connecté à un circuit haute fréquence respectif des première et seconde cartes de circuit imprimé (2, 3), et
chacun des connecteurs basse fréquence (15) est connecté à un circuit basse fréquence respectif des première et seconde cartes de circuit imprimé (2, 3), où chaque circuit basse fréquence est conçu pour fonctionner à une fréquence qui est inférieure à une fréquence à laquelle chaque circuit haute fréquence est conçu pour fonctionner.

3. Système (1) selon la revendication 1 ou la revendication 2, dans lequel chacun des connecteurs haute fréquence (14) est connecté à un circuit de courant alternatif respectif des première et seconde cartes de circuit imprimé (2, 3), et chacun des connecteurs basse fréquence (15) est connecté à un circuit de courant continu respectif des première et seconde cartes de circuit imprimé (2, 3).

4. Système (1) tel que revendiqué dans l'une quelconque des revendications précédentes, dans lequel la seconde carte de circuit imprimé (3) comprend, au niveau du connecteur haute fréquence (14), un circuit d'adaptation d'impédance respectif (7) comprenant un condensateur mis à la terre (Cpar) et un condensateur série (Cser2), où le condensateur série (Cser2) est un filtre passe-haut de l'un des filtres de séparation de fréquences (f) de la seconde carte de circuit imprimé (3).

5. Système (1) tel que revendiqué dans l'une quelconque des revendications précédentes, dans lequel la seconde carte de circuit imprimé (3) comprend une antenne (9) connectée au connecteur haute fréquence (14) du filtre de séparation de fréquences (f) de la seconde carte de circuit imprimé (3), et la première carte de circuit imprimé (2) comprend une unité de commande d'antenne (5) connectée au connecteur haute fréquence (14) du filtre de séparation de fréquences (f) de la première carte de circuit imprimé (2).

6. Système (1) selon la revendication 5, dans lequel l'antenne (9) est une antenne NFC et/ou GSM et/ou Bluetooth.

7. Système (1) tel que revendiqué dans l'une quelconque des revendications précédentes, dans lequel la seconde carte de circuit imprimé (3) comprend un capteur (10) connecté au connecteur basse fréquence (15) du filtre de séparation de fréquences (f) de la seconde carte de circuit imprimé (3), et la première carte de circuit imprimé (2) comprend une unité de contrôle de capteur (12) connectée au connecteur basse fréquence (15) du filtre de séparation de fréquences (f) de la première carte de circuit imprimé (2).

8. Système (1) selon la revendication 5, dans lequel la première carte de circuit imprimé (2) comprend un filtre passe-bas (6), et l'unité de contrôle d'antenne (12) est connectée aux filtres de séparation de fréquences (14) de la première carte de circuit imprimé (2) par l'intermédiaire du filtre passe-bas (6).

9. Système (1) tel que revendiqué dans l'une quelconque des revendications précédentes, dans lequel la première carte de circuit imprimé (2) et la seconde carte de circuit imprimé (3) sont disposées en sandwich dans un même boîtier (16).

10. Procédé pour transférer une tension basse fréquence et une tension haute fréquence entre une première carte de circuit imprimé (2) et une seconde carte de circuit imprimé (3), le procédé comprenant les étapes suivantes :
- transmettre la tension haute fréquence à un connecteur haute fréquence (14) d'un filtre de séparation de fréquences (f) de l'une des deux cartes de circuit imprimé (2, 3),
- transmettant la tension basse fréquence à un connecteur basse fréquence (15) du filtre de séparation de fréquences (f) de l'une des deux cartes de circuit imprimé (2, 3),
- combiner la tension haute fréquence et la tension basse fréquence en une tension à fréquences mélangées,
- transmettre la tension à fréquences mélangées d'un connecteur à fréquences mélangées (13) du filtre de séparation de fréquences (f) de la première carte de circuit imprimé (2) à un connecteur à fréquences mélangées (13) d'un filtre de séparation de fréquences (f) de l'autre des deux cartes de circuit imprimé (2, 3),
- séparer la tension à fréquences mélangées en la tension haute fréquence et en la tension basse fréquence,
- fournir la tension haute fréquence à un connecteur haute fréquence (14) d'un filtre de séparation de fréquences (f) de l'autre des deux cartes de circuit imprimé (2, 3), et
- fournir la tension basse fréquence à un connecteur basse fréquence (15) d'un filtre de séparation de fréquences (f) de l'autre des deux cartes de circuit imprimé (2, 3).
